# EUROPEAN PATENT APPLICATION

(11) **EP 2 472 630 A2**
(43) Date of publication of application: **04.07.2012**
(21) Application number: 11195573.8
(22) Date of filing: 23.12.2011
(51) Int. Cl.: H01L 51/56, H01L 51/00

(54) **Method for producing organic EL device and substrate for producing organic EL device**

(30) Priority: 28.12.2010 JP 2010294120
(71) Applicant: Nitto Denko Corporation, Osaka 567-8680 (JP)
(72) Inventor: Namikawa, Makoto, Osaka 567-8680 (JP)
(74) Representative: HOFFMANN EITLE

(57) **Abstract**

A method for producing an organic EL device includes the steps of: preparing an adhesive sheet (2) on which a resin substrate (3) is laminated: allowing the resin substrate to adhere onto a hard substrate (9) with the adhesive sheet interposed therebetween; forming an organic EL element (10) on the resin substrate, thereby producing an organic EL, device including the resin substrate and the organic EL element; and peeling the organic EL device from the hard substrate. The adhesive sheet includes a first adhesive layer (4) for being bonded to the hard substrate, and a second adhesive layer (6) formed on the first adhesive layer and bonded to the resin substrate. The adhesive strength of the first adhesive layer is different from the adhesive strength of the second adhesive layer.

## Description

### BACKGROUND OF THE INVENTION

### Field of the Invention

The present invention relates to a method for producing an organic EL device and a substrate for producing an organic EL device, in particular, to a method for producing an organic EL device, and a substrate for producing an organic EL device, the substrate being used in the method for producing an organic EL device.

### Description of Related Art

It has been known that an organic EL (electroluminescence) device includes a resin substrate, and an organic EL element laminated on the resin substrate.

As a method for producing such an organic EL device, for example, Japanese Unexamined Patent Publication No. 2009-271236 has proposed a method in which a resin substrate composed of polyethylenenaphthalate is allowed to adhere onto a glass substrate with an adhesive layer interposed therebetween, and then an organic EL element including an anode, a cathode, and an organic semiconductor layer is laminated on the resin substrate.

In Japanese Unexamined Patent Publication No. 2009-271236, after the production of the organic EL device, the glass substrate below the organic EL device is peeled from the resin substrate.

### SUMMARY OF THE INVENTION

However, in the method proposed in Japanese Unexamined Patent Publication No. 2009-271236, when the glass substrate is peeled from the resin substrate of the organic EL device, the peeling occurs at the interface between the adhesive layer and the glass substrate, and the adhesive layer remains at the surface of the resin substrate; or the peeling occurs at the interface between the adhesive layer and the resin substrate, and the adhesive layer remains at the surface of the glass substrate. Therefore, there are disadvantages, for example, stable production of organic EL devices cannot be achieved.

An object of the present invention is to provide a method for producing an organic EL device, and to a substrate for producing an organic EL device, the substrate being used in the method for producing an organic EL device: in the method, an interfacial peeling can be caused at a desired one interface out of the interface between the adhesive sheet and the resin substrate, and the interface between the adhesive sheet and the hard substrate.

A method for producing an organic EL device of the present invention includes the steps of: preparing an adhesive sheet on which a resin substrate is laminated; allowing the resin substrate to adhere onto a hard substrate with the adhesive sheet interposed therebetween; forming an organic EL element on the resin substrate, thereby producing an organic EL device including the resin substrate and the organic EL element; and peeling the organic EL device from the hard substrate, wherein the adhesive sheet includes a first adhesive layer for being bonded to the hard substrate, and a second adhesive layer formed on the first adhesive layer and bonded to the resin substrate, and the adhesive strength of the first adhesive layer is different from the adhesive strength of the second adhesive layer.

In the method for producing an organic EL device of the present invention, it is preferable that the adhesive strength of the first adhesive layer is higher than the adhesive strength of the second adhesive layer.

In the method for producing an organic EL device of the present invention, it is preferable that a supporting sheet is interposed between the first adhesive layer and the second adhesive layer.

A substrate for producing an organic EL device of the present invention is used for the method for producing an organic EL device, the method including the steps of: preparing an adhesive sheet on which a resin substrate is laminated; allowing the resin substrate to adhere onto a hard substrate with the adhesive sheet interposed therebetween; forming an organic EL element on the resin substrate, thereby producing an organic EL device including the resin substrate and the organic EL element; and peeling the organic EL device from the hard substrate, wherein the substrate includes the adhesive sheet and the resin substrate laminated on the adhesive sheet, the adhesive sheet includes a first adhesive layer for being bonded to the hard substrate and a second adhesive layer formed on the first adhesive layer and bonded to the resin substrate, and the adhesive strength of the first adhesive layer is different from the adhesive strength of the second adhesive layer.

In the substrate for producing an organic EL device of the present invention, it is preferable that the adhesive strength of the first adhesive layer is higher than the adhesive strength of the second adhesive layer.

In the substrate for producing an organic EL device of the present invention, it is preferable that a supporting sheet is further provided, the supporting sheet being interposed between the first adhesive layer and the second adhesive layer.

In the substrate for producing an organic EL device of the present invention, it is preferable that a shielding layer for preventing gas to permeate the resin substrate is formed on the top face of the resin substrate, and that a transparent conductive thin film formed on the top face of the shielding layer is further provided.

In the method for producing an organic EL device and the substrate for producing an organic EL device, the substrate being used in the method for producing an organic EL device of the present invention, the adhesive strength of the first adhesive layer is different from the adhesive strength of the second adhesive layer. Therefore, in the step of peeling the organic EL device from the hard substrate, the peeling can be caused at one of the interface between the first adhesive layer and the hard substrate, and the interface between the second adhesive layer and the resin substrate.

Therefore, the adhesive sheet can be left at only one of the resin substrate and the hard substrate, and can be prevented from remaining at the other of the resin substrate and the hard substrate.

Thus, stable production of organic EL devices can be achieved.

### BRIEF DESCRIPTION OF THE DRAWINGS

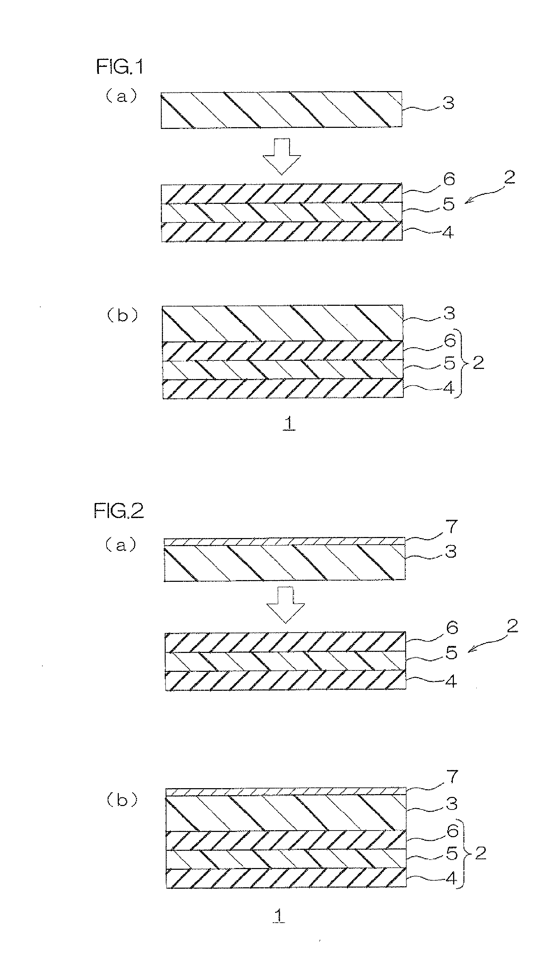

FIG. 1 is a process diagram for a method for producing a laminate substrate (embodiment in which an adhesive sheet and a resin substrate are included) as an embodiment of a substrate for producing an organic EL device of the present invention, the substrate being used in an embodiment of a method for producing an organic EL device of the present invention,
   (a) illustrating a step of preparing a resin substrate and an adhesive sheet, and
   (b) illustrating a step of laminating the resin substrate on the adhesive sheet.
FIG. 2 is a process diagram for producing a laminate substrate (embodiment in which an adhesive sheet, a resin substrate, and a shielding layer are included) as another embodiment of the substrate for producing an organic EL device of the present invention, the substrate being used in an embodiment of the method for producing an organic EL device of the present invention,
   (a) illustrating a step of preparing a resin substrate on which a shielding layer is laminated, and an adhesive sheet, and
   (b) illustrating a step of laminating the resin substrate on the adhesive sheet.

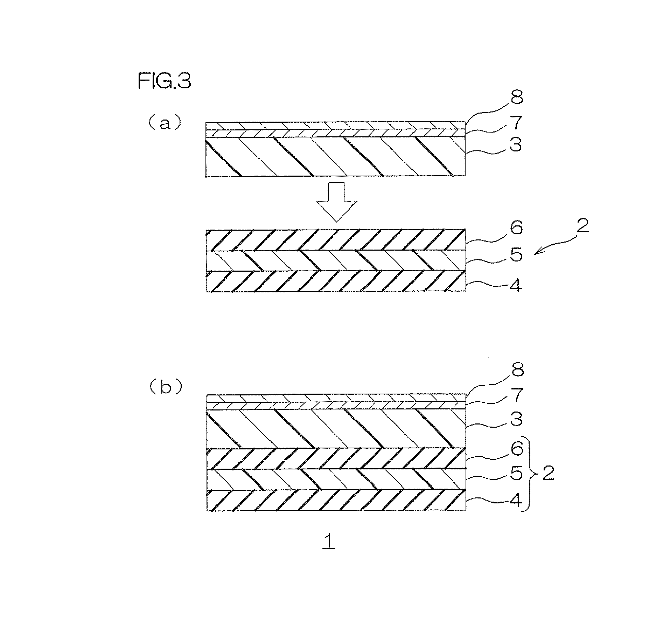

FIG. 3 is a process diagram for producing a laminate substrate (embodiment in which an adhesive sheet, a resin substrate, a shielding layer, and a transparent conductive thin film are included) as another embodiment of the substrate for producing an organic EL device, the substrate being used in an embodiment of the method for producing an organic EL device of the present invention,
   (a) illustrating a step of preparing a resin substrate on which a shielding layer and a transparent conductive thin film are laminated, and an adhesive sheet, and
   (b) illustrating a step of laminating the resin substrate and the adhesive sheet.

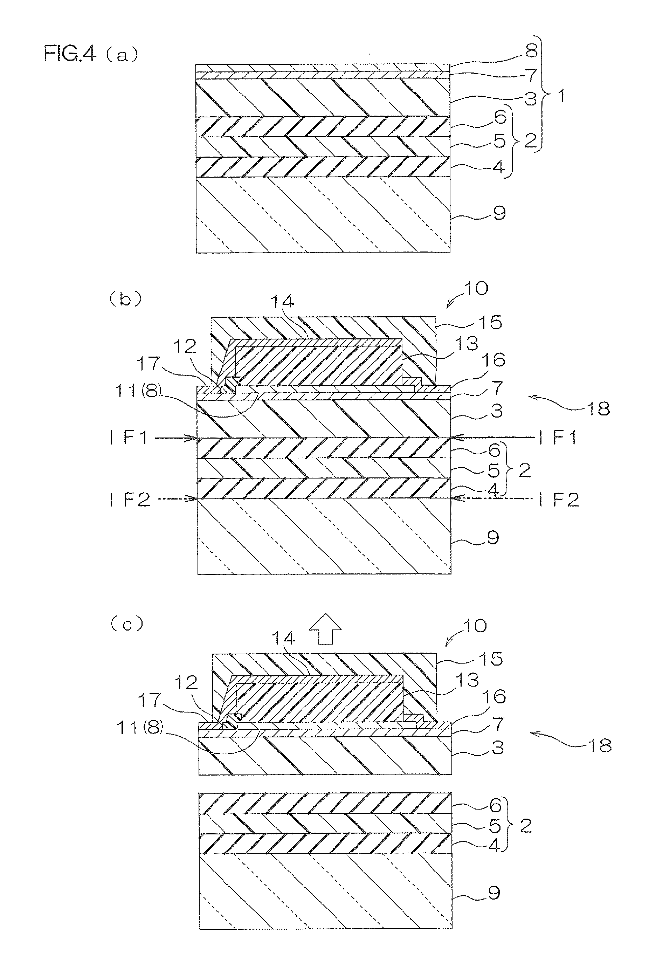

FIG. 4 is a process diagram for describing a method for producing an organic EL device using the laminate substrate shown in FIG. 3 (b),
   (a) illustrating a step of allowing the resin substrate to adhere onto the hard substrate with the adhesive sheet interposed therebetween, and
   (b) illustrating a step of forming an organic EL element on the resin substrate,
   (c) illustrating a step of peeling the organic EL device from the hard substrate (embodiment in which interfacial peeling is caused at the interface between the resin substrate and the second adhesive layer).

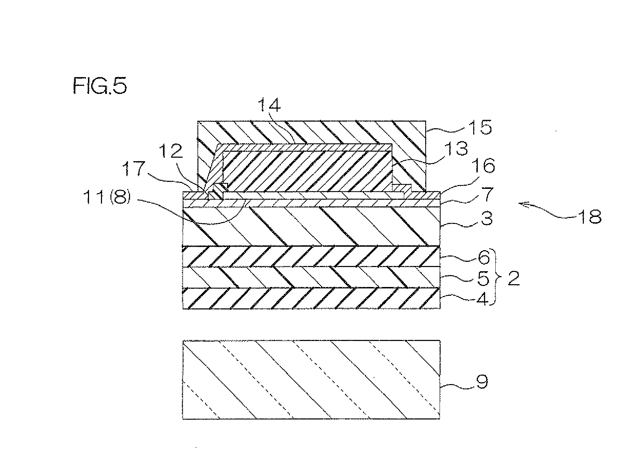

FIG. 5 is a process diagram for describing a method for producing an organic EL device using the laminate substrate shown in FIG. 3 (b), illustrating a step of peeling the organic EL device from the hard substrate (embodiment in which interfacial peeling is caused at the interface between the hard substrate and the first adhesive layer).

### DETAILED DESCRIPTION OF THE INVENTION

FIG. 1 to FIG. 3 show laminate substrates as an embodiment and another embodiment of the substrate for producing an organic EL device of the present invention, the substrate being used in an embodiment of the method for producing an organic EL device of the present invention, FIG. 1 shows an embodiment in which a laminate substrate includes an adhesive sheet and a resin substrate, FIG. 2 shows an embodiment in which the laminate substrate includes an adhesive sheet, a resin substrate, and a shielding layer, and FIG. 3 shows an embodiment in which the laminate substrate includes an adhesive sheet, a resin substrate, a shielding layer, and a transparent conductive thin film. FIG. 4 shows a process diagram for describing a method for producing an organic EL device using the laminate substrate shown in FIG. 3 (b).

In FIG. 1 (b), a laminate substrate 1 as an embodiment of the substrate for producing an organic EL device of the present invention includes an adhesive sheet 2 and a resin substrate 3 laminated on the adhesive sheet 2.

The adhesive sheet 2 includes a first adhesive layer 4, a supporting sheet 5 formed on the first adhesive layer 4, and a second adhesive layer 6 formed on the supporting sheet 5.

The supporting sheet 5 is interposed between the first adhesive layer 4 and the second adhesive layer 6, and is composed of, for example, a flexible sheet. Examples of such flexible materials include thermoplastic resins such as polyesters including polyethylene terephthalate (PET) and polyethylene naphthalate (PEN), and polyolefins including polyethylene and polypropylene. A preferable example is polyester.

The supporting sheet 5 has a thickness of, for example, 25 to 250 µm, preferably 25 to 75 µm.

The first adhesive layer 4 is formed below the entire bottom face of the supporting sheet 5.

The adhesive composition forming the first adhesive layer 4 is a pressure-sensitive adhesive composition in which a generation amount of a component that affects an organic EL layer 13 (ref: FIG. 4 (b)) to be described later is decreased, and contains, for example, an acrylic polymer.

Acrylic polymers are obtained, for example, by polymerizing a monomer component mainly composed of alkyl (meth)acrylate.

Alkyl (meth)acrylates include alkyl acrylates and/or alkyl methacrylates, and examples thereof include alkyl (meth)acrylate (alkyl moiety having 1 to 12 carbon atoms) having an alkyl moiety of a straight chain alkyl or a branched alkyl such as methyl (meth)acrylate, ethyl (meth)acrylate, n-propyl (meth)acrylate, isopropyl (meth)acrylate, n-butyl (meth)acrylate, isobutyl (meth)acrylate, sec-butyl (meth)acrylate, tert-butyl (meth)acrylate, n-pentyl (meth)acrylate, isopentyl (meth)acrylate, hexyl (meth)acrylate, heptyl (meth)acrylate, n-octyl (meth)acrylate, 2-ethylhexyl (meth)acrylate, isooctyl (meth)acrylate, nonyl (meth)acrylate, isononyl (meth)acrylate, n-decyl (meth)acrylate, isodecyl (meth)acrylate, undecyl (meth)acrylate, and dodecyl (meth)acrylate.

Alkyl (meth)acrylates can be used singly, or can be used in combination.

Of the above-described main components, preferably, alkyl acrylate (alkyl moiety having 2 to 8 carbon atoms) is used, and more preferably, ethyl acrylate or n-butyl acrylate is used.

The mixing ratio of alkyl (meth)acrylate relative to 100 mol of the monomer component is, for example, 50 to 99.9 mol, or preferably 60 to 99 mol. The mixing ratio of alkyl (meth)acrylate relative to 100 parts by mass of the monomer component is, for example, 50 to 99.9 parts by mass, or preferably 60 to 99 parts by mass.

The monomer component preferably contains a copolymerizable vinyl monomer that is copolymerizable with (meth)acrylate.

Examples of copolymerizable vinyl monomers include reactive group-containing vinyl monomers including hydroxyl group-containing vinyl monomers such as 2-hydroxyethyl (meth)acrylate, 3-hydroxypropyl (meth)acrylate, 4-hydroxybutyl (meth)acrylate, 5-hydraxypentyl (meth)acrylate, 6-hydroxyhexyl (meth)acrylate, 7-hydroxyheptyl (meth)acrylate, 8-hydroxyoctyl (meth)acrylate; and carboxyl group-containing vinyl monomers such as acrylic acid, methacrylic acid, fumaric acid, and maleic acid.

Examples of copolymerizable vinyl monomers also include poly functional vinyl monomers having a plurality of double bonds.

Examples of polyfunctional vinyl monomers include (mono or poly) alkyleneglycol di(meth)acrylate such as (mono or poly) ethylene glycol di(meth)acrylate including ethylene glycol di(meth)acrylate, diethylene glycol di(meth)acrylate, triethylene glycol di(meth)acrylate, and tetraethylene glycol di(meth)acrylate, (mono or poly) propylene glycol di(meth)acrylate such as propylene glycol di(meth)acrylate; as well as polyhydric alcohols of (meth)acrylate monomers such as neopentyl glycol di(meth)acrylate, 1,6-hexanediol di(meth)acrylate, pentaerythritol di(meth)acrylate, trimethylolpropane tri(meth)acrylate, pentaerythritol tri(meth)acrylate, and dipentaerythritolhexa (meth)acrylate.

Copolymerizable vinyl monomers can be used alone, or can be used in combination of two or more.

Preferably, a reactive group-containing vinyl monomer is used, and more preferably, a hydroxyl group-containing vinyl monomer is used. When a hydroxyl group-containing vinyl monomer is used, hydroxyl groups are allowed to react with a reactive vinyl monomer and/or a cross-linking agent to be described later, and the first adhesive layer 4 can achieve a stronger adhesive effects.

The mixing ratio of the copolymerizable vinyl monomer relative to 100 mol of the (meth)acrylate is, for example, 0.1 to 50 mol, preferably 1 to 40 mol. The mixing ratio of the copolymerizable vinyl monomer relative to 100 parts by mass of (meth)acrylate is, for example, 0.1 to 50 parts by mass, preferably 1 to 40 parts by mass.

Acrylic polymers can be obtained, for example, by allowing the above-described monomer component to react in the presence of a polymerization initiator by a known polymerization method such as, for example, solution polymerization, bulk polymerization, or emulsion polymerization. Preferably, solution polymerization using an aromatic solvent such as toluene as a solvent is employed.

Examples of polymerization initiators include thermal polymerization initiators and photopolymerization initiators.

Examples of thermal polymerization initiators include peroxide thermal polymerization initiators such as benzoyl peroxide, t-butylhydroperoxide, and hydrogen peroxide; and azo thermal polymerization initiators such as 2,2'-azobisisobutyronitrile, 2,2'-azobis(2-methylpropioneamidine)disulfate, 2,2'-azobis(2-methylpropioncamidine) dihydrochloride, 2,2'-azobis(2-amidinopropane) dihydrochloride, 2,2'-azobis[N-(2-carboxyethyl)-2-methylpropioneamidine]hydrate, 2,2'-azobis(N,N'-dimethyleneisobutylamidine), and 2,2'-azobis[2-(2-imidazoline-2-yl) propane] dihydrochloride.

Examples of photopolymerization initiators include a benzoin ether photopolymerization initiator, an acetophenone photopolymerization initiator, an α-ketol photopolymerization initiator, a ketal photopolymerization initiator, a benzoin photopolymerization initiator, a benzyl photopolymerization initiator, a benzophenone photopolymerization initiator, a thioxanthone photopolymerization initiator, and a substituted alkyl photopolymerization initiator.
Examples of benzoin ether photopolymerization initiators include benzoin methyl ether, benzoin ethyl ether, benzoin propyl ether, benzoin isopropyl ether, benzoin isobutyl ether, and 2,2-dimethoxy-1,2-dipbenylethan-1-one.

Examples of acetophenone photopolymerization initiators include 2,2-diethoxyacetophenone, 2,2-dimethoxy-2-phenylacetophenone, 1-hydroxycyclohexylphenylketone, 4-phenoxydichloroacetophenone, and 4-(t-butyl) dichloroacetophenone.

Examples of α-ketol photopolymerization initiators include 2-methyl-2-hydroxypropiophenone, and 1-[4-(2-hydroxyethyl) phenyl]-2-methylpropan-1-one.

Examples of ketal photopolymerization initiators include acetophenone dimethyl ketal and benzyldimethyl ketal.

Examples of benzoin photopolymerization initiators include benzoin.

Examples of benzyl photopolymerization initiators include benzyl and dibenzyl.

Examples of benzophenone photopolymerization initiators include benzophenone, benzoylbenzoic acid, 3,3'-dimethyl-4-methoxybenzophenone, potyvinylbenzophenone, and α-hydroxycyclohexylphenylketone,

Examples of thioxanthone photopolymerization initiators include thioxanthone, 2-chloirothioxanthone, 2-methylthioxanthone, 2,4-dimethylthioxanthone, isopropylthioxanthone, 2,4-diisopropylthioxanthone, dodecylthioxanthone, and Michler's ketone chlorothioxanthone.

Examples of substituted alkyl photopolymerization initiators include 2-hydroxydimethylphenylpropane, and 2,2-dimethoxy-2-phenylacetophenone.

Polymerization initiators can be used singly, or can be used in combination.

As the polymerization initiator, preferably, a thermal polymerization initiator, and more preferably, an azo thermal polymerization initiator is used.

The mixing ratio of the polymerization initiator relative to 100 mol of the monomer component is, for example, 0.01 to 1 mol. The mixing ratio of the polymerization initiator relative to 100 parts by mass of the monomer component is, for example, 0.01 to I part by mass.

The adhesive composition contains an acrylic polymer obtained as described above, and preferably, in addition to the above-described acrylic polymer, a reactive vinyl monomer, a cross-linking agent, and a polymerization initiator are blended therein.

The reactive vinyl monomer contains, for example, both of a reactive group (preferably, isocyanate group) that is capable of reacting with the reactive group (preferably, hydroxyl group) of the above-described copolymerizable vinyl monomer (reactive group-containing vinyl monomer, preferably a hydroxyl group-containing vinyl monomer); and a double bond.

Examples of such reactive vinyl monomers include an isocyanate group-containing vinyl monomer such as 2-(meth) acryloyloxy ethylisocyanate.

The cross-linking agent is nonvolatile, and has a weight-average molecular weight (a standard polystyrene-based value by GPC measurement) of, for example, 10000 or less, preferably, in view of effectively forming a three-dimensional network at the time of crosslinking (curing), 5000 or less.

Examples of such cross-linking agents include an isocyanate cross-linking agent, an oxazoline cross-linking agent, a carbodiimide cross-linking agent, an epoxy cross-linking agent, an aziridine cross-linking agent, and a metal chelate cross-linking agent. Preferably, an isocyanate cross-linking agent (e.g., trimethylol modified 2,4-tolylene diisocyanate) is used.

As the polymerization initiator, the above-described polymerization initiators, preferably a photopolymerization initiator, and more preferably, a ketal photopolymerization initiator is used.

Reactive vinyl monomers, cross-linking agents, and polymerization initiators can be used alone, or can be used in combination of two or more.

Reactive vinyl monomers, cross-linking agents, and polymerization initiators can be blended in at the same time with the acrylic polymer, or can be blended sequentially at an appropriate timing.

Preferably, a reactive vinyl monomer is blended with an acrylic polymer; the mixture is allowed to react by heating the mixture to 30 to 60°C; and thereafter, a cross-linking agent and a polymerization initiator are blended into the mixture.

In the reaction between the acrylic polymer and the reactive vinyl monomer, the reactive group (hydroxyl group) of the copolymerizable vinyl monomer and the reactive group (isocyanate group) of the reactive vinyl monomer are allowed to react with each other (chemically bond). A double bond is introduced into the side chain of the acrylic polymer in this manner, thereby becoming a curable acrylic polymer (polymerizable acrylic polymer).

After the reaction, the product containing the curable acrylic polymer can be washed (refined) to remove by-products (e.g., low molecule weight component). The refinement is performed, for example, by reprecipitation method.

The weight-average molecular weight (a standard polystyrene-based value by GPC measurement) of the refined curable acrylic polymer is, for example, 100000 to 1000000, and the component having a molecule weight of 100000 or less is, for example, 10.0 mass% or less.

The reactive vinyl monomer is blended so that the reactive group (isocyanate group) of the reactive vinyl monomer relative to 100 mol of the reactive group (hydroxyl group) of the copolymerizable vinyl monomer is, for example, below 100 mol, preferably 1 to 95 mol. As described later, by adding, for example, thermal or optical energy thereafter to the curable acrylic polymer, the double bond portion of the curable acrylic polymer is further polymerized (that is, crosslinked (self-crosslinked)), and cured.

When a cross-linking agent is blended into the curable acrylic polymer, the cross-linking agent is, in curing reaction thereafter, polymerized (that is, crosslinked) with the double bond portion of the curable acrylic polymer.

The mixing ratio R1 of the cross-linking agent relative to 100 parts by mass of the curable acrylic polymer (total amount of the acrylic polymer and the reactive vinyl monomer) is, for example, 0.2 to 20 parts by mass, preferably 0.5 to 5 parts by mass.

When the polymerization initiator is blended into the curable acrylic polymer, the polymerization initiator accelerates the above-described polymerization reaction (crosslinking reaction) in the curing reaction thereafter.

The mixing ratio of the polymerization initiator relative to 100 parts by mass of the curable acrylic polymer (total amount of the acrylic polymer and the reactive vinyl monomer) is, for example, 0.2 to 20 parts by mass, preferably 1 to 10 parts by mass.

An adhesive composition in which a curable acrylic polymer, a cross-linking agent, and a polymerization initiator are blended is regarded as a curable adhesive composition.

Then, the above-described adhesive composition is applied on the surface (bottom face) of the supporting sheet 5 by a known method, and thereafter dried, thereby producing a first adhesive layer 4.

The first adhesive layer 4 has a thickness of, for example, 1 to 200 µm, preferably 5 to 50 µm.

In the first adhesive layer 4, the above-described polymerization reaction (crosslinking reaction) progresses in the curing thereafter, and in this fashion, stronger adhesive effects are achieved.

A second adhesive layer 6 is formed on the entire top face of the supporting sheet 5.

The adhesive composition forming the second adhesive layer 6 is a pressure-sensitive adhesive composition, and for example, contains the above-described acrylic polymer. Preferably, an acrylic polymer, a reactive vinyl monomer, a polymerization initiator, and a cross-linking agent are blended in the adhesive composition forming the second adhesive layer 6, and more preferably, the adhesive composition forming the second adhesive layer 6 is a polymerizable adhesive composition in which a curable acrylic polymer, a cross-linking agent, and a polymerization initiator are blended.

The adhesive composition forming the second adhesive layer 6 is, although described later, is prepared so that its adhesive strength A2 after curing is different from an adhesive strength A1 after curing of the first adhesive layer 4.

To be specific, a mixing ratio R2 (mixing ratio relative to 100 parts by mass of the curable acrylic polymer) of the cross-linking agent blended in the adhesive composition forming the second adhesive layer 6 is, compared with the mixing ratio R1 (mixing ratio relative to 100 parts by mass of the curable acrylic polymer) of the cross-linking agent blended in the adhesive composition forming the first adhesive layer 4, preferably low, to be specific, the ratio of R2 to R1 ( = R2/R1) is, for example, below 1, preferably 0.001 to 0.999, and more preferably 0.01 to 0.5.

To be specific, the mixing ratio R2 of the cross-linking agent blended in the adhesive composition forming the second adhesive layer 6 relative to 100 parts by mass of the curable acrylic polymer is, for example, 0.1 to 10 parts by mass, preferably 0.5 to 5 parts by mass.

The mixing ratio of the components in the monomer component of the acrylic polymer of the adhesive composition forming the second adhesive layer 6 relative to the reactive vinyl monomer and the polymerization initiator blended in the acrylic polymer can be the same as that of the first adhesive layer 4, or can be different. Preferably, the mixing ratio is the same.

The above-described adhesive composition is applied on the surface (top face) of the supporting sheet 5 by a known method, and thereafter dried, thereby producing the second adhesive layer 6.

The second adhesive layer 6 has a thickness of, for example, 0.5 to 100 µm, preferably 1 to 25 µm.

In the second adhesive layer 6, polymerization reaction (crosslinking reaction) progresses by the subsequent curing, and this allows achievement of more strong adhesive effects.

The resin substrate 3 is laminated, as shown in FIG. 1 (b), on the entire top face of the first adhesive layer 4.

The resin substrate 3 is composed of a transparent or flexible sheet, and examples of such a transparent flexible material include the above-described thermoplastic resins. Preferably, in view of low costs, polyester is used.

The resin substrate 3 has a thickness of, for example, 1 to 500 µm, preferably 10 to 100 µm.

To obtain the laminate substrate 1, the resin substrate 3 and the adhesive sheet 2 are prepared individually, and then the resin substrate 3 is bonded to the top face of the second adhesive layer 6 of the adhesive sheet 2. In other words, the second adhesive layer 6 is bonded to the bottom face of the resin substrate 3.

The laminate substrate 1 including the adhesive sheet 2 and the resin substrate 3 can be obtained in this manner.

In the description for FIG. 1 (a) above, the supporting sheet 5 is interposed between the first adhesive layer 4 and the second adhesive layer 6 in the adhesive sheet 2. However, for example, although not shown, the adhesive sheet 2 can be formed from the first adhesive layer 4 and the second adhesive layer 6 without providing the supporting sheet 5 between the first adhesive layer 4 and the second adhesive layer 6. In such a case, the first adhesive layer 4 and the second adhesive layer 6 are directly in contact and bonded with each other.

Preferably, as shown in FIG. 1 (a), in the adhesive sheet 2, the supporting sheet 5 is interposed between the first adhesive layer 4 and the second adhesive layer 6.

In this way, the first adhesive layer 4 and the second adhesive layer 6 are easily laminated, and moreover, peeling of the organic EL device 18 from the hard substrate 9 described later (ref: FIG. 4 (c)) can be performed easily.

Furthermore, as shown in FIG. 2 (b), a shielding layer 7 can also be provided in the laminate substrate 1.

The shielding layer 7 is formed on the entire top face of the resin substrate 3. The shielding layer 7 is a gas barrier layer for preventing (blocking) gas from permeating the resin substrate 3, and to shield an organic EL layer 13 (ref: FIG. 4 (b)) to be described later. Examples of gases include water vapor, and air (including oxygen).

Examples of materials forming the shielding layer 7 include inorganic materials such as SiN, SiC, and thin-film metals.

The shielding layer 7 has a thickness of, for example, 0.01 to 100 µm, preferably 0.1 to 10 µm.

To obtain such a laminate substrate 1, as shown in FIG. 2 (a), for example, the shielding layer 7 is formed on the resin substrate 3 by sputtering, and thereafter, as shown in FIG. 2 (b), the resin substrate 3 having the shielding layer 7 formed thereon is bonded on the second adhesive layer 6 of the adhesive sheet 2.

As shown in FIG. 3 (b), a transparent conductive thin film 8 can also be provided on the above-described laminate substrate 1 in addition to the above-described shielding layer 7.

The transparent conductive thin film 8 is formed on the entire top face of the shielding layer 7. The transparent conductive thin film 8 will be an electrode (to be specific, an anode 11, ref: FIG. 4 (b)) by patterning to be described later.

Examples of transparent conductive materials that form the transparent conductive thin film 8 include oxides such as indium-tin composite oxide (ITO).

The transparent conductive thin film 8 has a thickness of, for example, 10 to 1000 nm, preferably 50 to 500 nm.

Such a transparent conductive thin film 8 has a surface resistance of, for example, in view of ensuring a predetermined transparency, 1 to 50Ω/□. The surface resistance is measured by the four probe method.

By providing the transparent conductive thin film 8 on the laminate substrate 1 in advance, in the step of forming the anode 11 (ref: FIG. 4 (b)) thereafter, the anode 11 can be formed easily just by patterning without laminating the transparent conductive thin film 8 separately.

To obtain such a laminate substrate 1, for example, first, as shown in FIG. 2 (a), the shielding layer 7 is formed on the resin substrate 3, then, as shown in FIG. 3 (a), the transparent conductive thin film 8 is formed on the shielding layer 7. The transparent conductive thin film 8 is formed, for example, by a known thin film forming method, such as vapor deposition including vacuum deposition.

Thereafter, as shown in FIG. 3 (b), the resin substrate 3 with the shielding layer 7 and the transparent conductive thin film 8 formed successively thereon is bonded on the second adhesive layer 6 of the adhesive sheet 2.

Next, a method for producing an organic EL device 18 using the laminate substrate 1 shown in FIG. 3 (b) is described with reference to FIG. 4.

In this method, as shown in FIG. 3 (b), first, an adhesive sheet 2 with the resin substrate 3 laminated thereon, that is, the above-described laminate substrate 1 is prepared.

Next, in this method, as shown in FIG. 4 (a), the resin substrate 3 of the laminate substrate 1 is allowed to adhere onto a hard substrate 9 with the adhesive sheet 2 interposed therebetween.

That is, by bonding the first adhesive layer 4 of the adhesive sheet 2 to the top face of the hard substrate 9, the resin substrate 3 is allowed to adhere onto the hard substrate 9. In other words, the bottom face of the first adhesive layer 4 is bonded to the hard substrate 9.

Examples of hard materials that form the hard substrate 9 include inorganic hard materials such as glass, ceramics, and metal (e.g., iron, aluminum, and stainless steel). Preferably, in view of transparency (ease of light irradiation of the adhesive composition to be described later), when a photopolymerization initiator is blended in the curable acrylic polymer, glass is used.

The hard substrate 9 has a thickness of, for example, 0.5 to 2 mm.

Next, in this method, as shown in FIG. 4 (b), an organic EL element 10 is formed on the resin substrate 3.

The organic EL element 10 is a known organic EL element, and includes, for example, an anode 11, an insulating layer 12, the organic EL layer 13, and a cathode 14. The organic EL element 10 also include, for example, a sealing layer 15, an anode terminal 16 connected to the anode 11, and a cathode terminal 17.

The anode 11 is formed on the shielding layer 7, and is formed, for example, by forming the transparent conductive thin film 8 shown in FIG. 4 (b) into a pattern by a known patterning method such as etching.

The insulating layer 12 is formed on the shielding layer 7 so as to cover one end of the transparent conductive thin film 8.

The organic EL layer 13 is formed on the anode 11 and the insulating layer 12.

The cathode 14 is formed on the shielding layer 7 and the insulating layer 12 so as to cover the organic EL layer 13.

The sealing layer 15 is formed to cover one end, and to expose the other end of the cathode 14. The other end of the cathode 14 exposed from the sealing layer 15 serves as the cathode terminal 17.

The anode terminal 16 is formed so that one end thereof is in contact with the anode 1 I and is sealed in with the sealing layer 15, and the other end thereof is exposed from the sealing layer 15.

Examples of materials for the members included in the organic EL element 10 are those materials for the members included in a known organic EL element. Examples of electrode materials that form the anode 11 include the above-described transparent conductive materials.

To form the above-described organic EL element 10 on the resin substrate 3, for example, first, the anode 11 is formed from the transparent conductive thin film 8 by a known patterning method.

Then, the insulating layer 12, the organic EL layer 13, the cathode 14 (including the cathode terminal 17), the anode terminal 16, and the sealing layer 15 are formed successively by a known method.

The organic EL element 10 formed on the resin substrate 3 (shielding layer 7) is obtained in this manner.

In this fashion, an organic EL device 18 including the resin substrate 3, the shielding layer 7, and the organic EL element 10 that is allowed to adhere onto the hard substrate 9 with the adhesive sheet 2 interposed therebetween is produced.

Thereafter, when the adhesive composition in the first adhesive layer 4 and the second adhesive layer 6 contains a curable acrylic polymer and/or a cross-linking agent, the curable acrylic polymer and/or the cross-linking agent are allowed to react by energy of, for example, heat or light.

Preferably, the adhesive composition is cured by light irradiation to allow polymerization reaction of double bonds in the curable acrylic polymer to progress.

In particular, light, preferably, ultraviolet light, to be specific, ultraviolet light having a wavelength of 100 to 400 nm is used to irradiate from the hard substrate 9 side toward the adhesive sheet 2.

The irradiation is performed such that the adhesive sheet 2 is exposed at, for example, 100 to 10000 mJ/cm² in total.

The adhesive composition is thus cured.

In the adhesive sheet 2 of the laminate substrate 1, the adhesive strength A1 of the cured first adhesive layer 4 is different from the adhesive strength A2 of the cured second adhesive layer 6.

Preferably, the adhesive strength A1 of the cured first adhesive layer 4 is set higher than the adhesive strength A2 of the cured second adhesive layer 6. In this way, although described later, by causing interfacial peeling at interface IF 1 (solid line arrow in FIG. 4 (b)) between the second adhesive layer 6 and the resin substrate 3, the adhesive sheet 2 (first adhesive layer 4) that is unnecessary for the organic EL device 18 can be prevented from remaining (sticking) at the resin substrate 3.

The ratio of the adhesive strength A1 of the cured first adhesive layer 4 relative to the adhesive strength A2 of the cured second adhesive layer 6 ( = A1/A2) is, for example, 0.99 or less, preferably 0.9 or less, and more preferably 0.7 or less; and usually, the ratio is 0.01 or more, preferably 0.1 or more. When the above-described ratio (A1/A2) exceeds the above-described range, the difference between the adhesive strength A1 of the cured first adhesive layer 4 and the adhesive strength A2 of the cured second adhesive layer 6 is insufficient, and the interfacial peeling described later may not be achieved.

To be specific, subtraction of the adhesive strength A1 of the cured first adhesive layer 4 from the adhesive strength A2 of the cured second adhesive layer 6 (= A2-A1) gives, for example, 0.01 to 10 (1.02 to 1020 gf/20 mm), preferably 0.1 to 1.0 (10.2 to 102 gf/20 mm).

The adhesive strength of the adhesive sheets is measured in conformity with JIS Z0237, the 180 degree peel adhesion (peel adhesion) relative to the silicon wafer.

Thereafter, as shown by the arrow in FIG. 4 (c), the organic EL device 18 is peeled upward from the hard substrate 9.

That is, when the adhesive strength A2 of the second adhesive layer 6 is lower than the adhesive strength A1 of the first adhesive layer 4, the interfacial peeling occurs at the interface IF1 (solid line arrow in FIG. 4 (b)) between the top face of the second adhesive layer 6 and the bottom face of the resin substrate 3.

Therefore, the adhesive sheet 2 remains (sticks) on the hard substrate 9, as shown in FIG. 4 (c).

By contrast, when the adhesive strength A2 of the second adhesive layer 6 is higher than the adhesive strength A1 of the first adhesive layer 4, as shown in FIG. 5, the interfacial peeling occurs at the interface (phantom line arrow in FIG. 4) between the bottom face of the first adhesive layer 4 and the top face of the hard substrate 9.

Therefore, the adhesive sheet 2 remains (sticks) on the resin substrate 3.

By the above-described peeling, the organic EL device 18 can be obtained.

In the above-described method, the adhesive strength A1 of the cured first adhesive layer 4 is different from the adhesive strength A2 of the cured second adhesive layer 6. Thus, in the step of peeling the organic EL device 18 from the hard substrate 9, peeling can be caused at one of the interface IF1 between the first adhesive layer 4 and the hard substrate 9, and the interface IF2 between the second adhesive layer 6 and the resin substrate 3.

Therefore, the adhesive sheet 2 can be allowed to remain at only one of the resin substrate 3 and the hard substrate 9, thus preventing the adhesive sheet 2 from remaining at the other.

Therefore, stable production of the organic EL device 18 is achieved.

In particular, when the adhesive strength A1 of the cured first adhesive layer 4 is higher than the adhesive strength A2 of the cured second adhesive layer 6, as shown in TIG. 4 (c), the interfacial peeling can be caused at the interface IF1 (FIG. 4 (b) solid line arrow) between the top face of the second adhesive layer 6 and the bottom face of the resin substrate 3.

In this fashion, the adhesive sheet 2 is allowed to remain at only the top face of the hard substrate 9, thus preventing the adhesive sheet 2 unnecessary for the organic EL device 18 from remaining (sticking) at the bottom face of the resin substrate 3.

Therefore, the organic EL device 18 can be produced with excellent reliability. Examples

Hereinafter, the present invention is described in further detail with reference to Preparation Examples, Examples, and Comparative Examples. However, the present invention is not limited to those described in these Examples.

Preparation Example 1

(Preparation of Adhesive Composition A)

To a 500 ml reactor having a thermometer, a mixer, a nitrogen inlet tube, and a reflux condensing tube, a monomer component (180.6 g) containing 0.59 mol (59 g) of ethyl acrylate, 0.59 mol (75.5 g) of n-butyl acrylate, and 0.26 mol (45.8 g) of acrylic acid 6-hydroxyhexyl; 2 mmol (0.33 g) of 2,2'-azobisisobutyronitrile; and 19.4 g of toluene were placed and stirred while introducing nitrogen gas for 1 hour, and air in the reactor was replaced with nitrogen.
Thereafter, the system was heated at a temperature of 60°C, and such a state was kept for 6 hours, thereby causing polymerization reaction of the above-described monomer component, and producing a toluene solution of acrylic polymer.

Subsequently, in the toluene solution of acrylic polymer, 0.21 mol (50.8 g) of 2-methacryloyloxyethylisocyanate (reactive vinyl monomer) was blended, and the mixture was heated to 55°C, thereby allowing reaction to occur. That is, the hydroxyl group in the acrylic acid 6-hydroxyhexyl and the isocyanate group in the 2-methacryloyloxyethylisocyanate were allowed to react in a polycondensation reaction, thereby producing a curable acrylic polymer in which an unsaturated bond (carbon-carbon double bond) was introduced in the side chain of the acrylic polymer.

The chain length of the side chain (to be specific, -COO-(CH₂)₆-OCONH-C₂H₄-COC (CH₃) = CH₂) of the curable acrylic polymer is, 16 by the number of atoms (number of atoms (such as C, O, and N) arranged in series in the side chain, C was 13, O was 2, N was 1).

Thereafter, the obtained curable acrylic polymer was purified by methanol reprecipitation method, thereby removing low molecule weight components. In the purified curable acrylic polymer, the weight-average molecular weight calculated by a standard polystyrene-based value by GPC measurement was 600000, and the component having a molecule weight of 100000 or less was 7.3 wt%.

Then, 2 parts by mass of a cross-linking agent (trade name: CORONATER L, isocyanate cross-linking agent, trimethylol modified 2,4-tolylene diisocyanate, isocyanate content 12.7 to 13.7 mass%, manufactured by Nippon Polyurethane Industry Co., Ltd.), and 5 parts by mass of a photopolymerization initiator (Irgacure 65 1, benzyldimethylketal, manufactured by Ciba Specialty Chemicals plc.) were added to 100 parts by mass of the curable acrylic polymer, and the mixture was blended uniformly, thereby producing an adhesive composition A.

Preparation Example 2

(Preparation of adhesive composition B)

An adhesive composition B was prepared in the same manner as in the preparation of the adhesive composition A, except that the blending parts by mass of the cross-linking agent (trade name: CORONATER L) relative to 100 parts by mass of the curable acrylic polymer was changed from 2 parts by mass to 1 part by mass.

Example 1

(Production of laminate substrate)

A supporting sheet composed of PET and having a thickness of 25 µm was prepared, and the adhesive composition B of Preparation Example 2 was applied on one side (top face) of the supporting sheet so that the thickness after drying thereof was 5 µm, and thereafter dried, thereby forming a second adhesive layer.

Subsequently, the adhesive composition A of Preparation Example 1 was applied on the other side (bottom face) of the of the supporting sheet so that the thickness after drying thereof was 10 µm, and dried, thereby forming a first adhesive layer. An adhesive sheet including the first adhesive layer and the second adhesive layer with the supporting sheet interposed therebetween was thus made (ref: FIG. 3 (a)).

Separately, a resin substrate composed of PET with a thickness of 50 µm was prepared; then, a shielding layer composed of SiC with a thickness of 0.5 µm was formed on the top face of the resin substrate by sputtering (ref: FIG. 2 (a)); and thereafter, a transparent conductive thin film composed of ITO with a thickness of 130 nm was formed on the top face of the shielding layer by vacuum deposition (ref: FIG. 3 (a)).

The surface resistance (sheet resistance) of the transparent conductive thin film was measured and found to be 10Ω/□.

Thereafter, the resin substrate with the shielding layer and the transparent conductive thin film formed thereon successively was bonded on the top face of the second adhesive layer of the adhesive sheet. An adhesive sheet in which the resin substrate, the shielding layer, and the transparent conductive thin film were laminated thereon successively, that is, a laminate substrate was thus made (ref: FIG. 3 (b)).

(Production of organic EL device)

The resin substrate of the laminate substrate was allowed to adhere onto a hard substrate composed of glass with a thickness of 0.75 mm, and a size of 100 mm x 100 mm with the adhesive sheet interposed therebetween (ref: FIG. 4 (a)).

That is, by bonding the first adhesive layer of the adhesive sheet on the top face of the hard substrate, the resin substrate was allowed to adhere onto the hard substrate.

Then, an organic EL element was formed on the resin substrate. To be specific, the laminate substrate and the hard substrate were introduced into an organic EL element prototype test system (Try-ELVESS, manufactured by TOKKI Corporation), and an organic EL element was made on the shielding layer (ref: FIG. 4 (b)).

In this fashion, an organic EL device including the resin substrate, the shielding layer, and the organic EL element was produced on the adhesive sheet.

Thereafter, ultraviolet rays having a center wavelength of 365 nm was irradiated from the hard substrate side toward the adhesive sheet, at a total exposure of 1500 mJ/cm².

The adhesive composition was thus cured.

Thereafter, the organic EL device was peeled from the resin substrate (ref: FIG. 4 (c)).

Thereafter, the bottom face of the resin substrate was observed, and it was confirmed that the adhesive sheet did not remain.

That is, interfacial peeling occurred at the interface (IF1) between the resin substrate and the adhesive sheet (second adhesive layer).

A series of the above-described production of an organic EL device, curing of an adhesive sheet, and peeling of an organic EL device was repeated a plurality of times.

It was confirmed from the result that in any of the cases, the adhesive sheet did not remain at the bottom face of the resin substrate.

Comparative Example 1

A laminate substrate was produced, and then production of an organic EL device, curing of an adhesive sheet, and peeling of the organic EL device were performed in the same manner as in Example 1, except that in the production of the laminate substrate, the first adhesive layer and the second adhesive layer were formed from the same adhesive composition A.

Then, a series of the above-described operation was repeated a plurality of times.

It was confirmed from the result that the second adhesive layer remained (stuck) at the bottom face of the resin substrate of the organic EL device, or that the first adhesive layer remained at the top face of the hard substrate.

That is, interfacial peeling occurred at both of the interface (IF2, ref: phantom line arrow in FIG. 4 (b)) between the hard substrate and the adhesive sheet (first adhesive layer), and at the interface (IF1, ref: solid line arrow in FIG. 4 (b)) between the resin substrate and the adhesive sheet (second adhesive layer).

Comparative Example 2

A laminate substrate was made by bonding a resin substrate in which a shielding layer and a transparent conductive thin film were formed thereon successively on the top face of the adhesive sheet, and then production of an organic EL, device, curing of an adhesive sheet, and peeling of the organic EL device were performed in the same manner as in Example 1, except that in the production of the laminate substrate, an adhesive sheet (that is, an adhesive sheet composed only of one layer of a first adhesive layer, without providing a second adhesive layer and a supporting sheet) composed only of the first adhesive layer was prepared.

Then, a series of the above-described operation was repeated a plurality of times.

It was confirmed from the result that the first adhesive layer remained (stuck) at the bottom face of the resin substrate of the organic EL device, or the first adhesive layer remained on the top face of the hard substrate.

That is, interfacial peeling occurred at the interface (IF2, ref: phantom line arrow in FIG. 4 (b)) between the hard substrate and the adhesive sheet, or at the interface (IF1, ref: solid line arrow in FIG. 4 (b)) between the resin substrate and the adhesive sheet.

(Evaluation of adhesive strength of cured first adhesive layer and second adhesive layer)

An adhesive composition A and an adhesive composition B were applied separately on a corona treated surface of a PET sheet having a thickness of 38 µm so that their thickness after drying was 20 µm, and thereafter dried, thereby forming a first adhesive layer and a second adhesive layer individually.

Thereafter, the PET sheet with the adhesive layers formed was processed to give a width of 20 mm per each adhesive layer, and then PET sheets were bonded to the mirror face of a silicon wafer (silicon substrate) with respective adhesive layers interposed therebetween.

Thereafter, the adhesive layers were irradiated with ultraviolet rays having a center wavelength of 365 nm by a high-pressure mercury lamp, at a total exposure of 1500 mJ/cm² from the PET sheet side, thereby curing the adhesive layers.

Thereafter, in conformity with JIS Z0237, the 180 degree peel adhesion (peel adhesion) of the adhesive layers from the silicon wafer was measured.

As a result, it was found that the peel adhesion of the first adhesive layer was 0.59N (60.2 gf/20 mm), and the peel adhesion of the second adhesive layer was 0.030N (3.06 gf/20 mm).

## Claims

1. A method for producing an organic EL device, the method comprising the steps of:
preparing an adhesive sheet on which a resin substrate is laminated,
allowing the resin substrate to adhere onto a hard substrate with the adhesive sheet interposed therebetween,
forming an organic EL element on the resin substrate, thereby producing an organic EL device including the resin substrate and the organic EL element, and
peeling the organic EL device from the hard substrate,
wherein the adhesive sheet comprises
a first adhesive layer for being bonded to the hard substrate, and
a second adhesive layer formed on the first adhesive layer and bonded to the resin substrate, and
the adhesive strength of the first adhesive layer is different from the adhesive strength of the second adhesive layer.

2. The method for producing an organic EL device according to Claim 1, wherein the adhesive strength of the first adhesive layer is higher than the adhesive strength of the second adhesive layer.

3. The method for producing an organic EL device according to Claim 1 or 2, wherein a supporting sheet is interposed between the first adhesive layer and the second adhesive layer.

4. A substrate suitable for producing an organic EL device by means of the method according to any one of Claims 1 to 3,
wherein the substrate comprises an adhesive sheet and a resin substrate laminated on the adhesive sheet,
the adhesive sheet comprises a first adhesive layer, and a second adhesive layer formed on the first adhesive layer,
wherein said second adhesive layer is bonded to the resin substrate, and
the adhesive strength of the first adhesive layer is different from the adhesive strength of the second adhesive layer.

5. The substrate suitable for producing an organic EL device according to Claim 4, wherein the adhesive strength of the first adhesive layer is higher than the adhesive strength of the second adhesive layer.

6. The substrate suitable for producing an organic EL device according to Claim 4 or 5 , wherein a supporting sheet is interposed between the first adhesive layer and the second adhesive layer.

7. The substrate suitable for producing an organic EL device according to Claim 4, 5 or 6 , further comprising a shielding layer for preventing gas to permeate the resin substrate, the shielding layer being formed on the top face of the resin substrate.

8. The substrate suitable for producing an organic EL device according to Clam 7, further comprising a transparent conductive thin film formed on the top face of the shielding layer.
